# EUROPEAN PATENT APPLICATION

(11) **EP 4 579 473 A1**
(43) Date of publication of application: **02.07.2025**
(21) Application number: 23869795.7
(22) Date of filing: 27.06.2023
(51) Int. Cl.: G06F 16/174

(54) **DATA COMPRESSION METHOD, APPARATUS, COMPUTING DEVICE, AND STORAGE SYSTEM**

(30) Priority: 29.09.2022 CN 202211202660
(71) Applicant: Huawei Technologies Co., Ltd., Shenzhen, Guangdong 518129 (CN)
(72) Inventor: YIN, Qingyun, Shenzhen, Guangdong 518129 (CN); ZHANG, Liangxiang, Shenzhen, Guangdong 518129 (CN); NIU, Jinbao, Shenzhen, Guangdong 518129 (CN); WU, Jinkang, Shenzhen, Guangdong 518129 (CN)
(74) Representative: Goddar, Heinz J.
(86) International application number: PCT/CN2023/102962
(87) International publication number: WO 2024/066547

(57) **Abstract**

A data compression method and apparatus, a computing device, and a storage system are provided, and relate to the field of data compression. The data compression method includes: When a computing device compresses a to-be-compressed file, the computing device determines a compression algorithm of the to-be-compressed file based on a content feature of the to-be-compressed file; and compresses the to-be-compressed file based on the compression algorithm to obtain compressed data, and stores the compressed data. In this way, compared with compressing, by a computing device, files with different content features by using one compression algorithm, in the data compression method provided in this application, the compression algorithm used by the computing device is selected based on the content feature of the to-be-compressed file, and the to-be-compressed file is compressed by using the compression algorithm that matches the content feature of the to-be-compressed file, so that a data compression ratio can be effectively improved, to enable a storage device to store more data, thereby improving storage space utilization of the storage device.

## Description

This application claims priority to Chinese Patent Application No. 202211202660.9, filed with the China National Intellectual Property Administration on September 29, 2022 and entitled "DATA COMPRESSION METHOD AND APPARATUS, COMPUTING DEVICE, AND STORAGE SYSTEM", which is incorporated herein by reference in its entirety.

### TECHNICAL FIELD

This application relates to the field of data compression, and in particular, to a data compression method and apparatus, a computing device, and a storage system.

### BACKGROUND

Currently, a computing device may compress to-be-stored data by using a compression algorithm (for example, GZIP or WINRAR) and then store the compressed data. This reduces a data amount through reducing redundant and repeated data, to reduce storage space occupied by the data, thereby improving a transmission rate and processing efficiency of the data, and the like. However, in the computing device, after a user sets a compression algorithm, data compression is performed on all data based on the specified compression algorithm, resulting in a low data compression ratio.

### SUMMARY

This application provides a data compression method and apparatus, a computing device, and a storage system, to improve a data compression ratio.

According to a first aspect, a data compression method is provided. The method includes: When a computing device compresses a to-be-compressed file, the computing device determines a compression algorithm of the to-be-compressed file based on a content feature of the to-be-compressed file; and compresses the to-be-compressed file based on the compression algorithm to obtain compressed data, and stores the compressed data.

In this way, compared with compressing, by a computing device, files with different content features by using one compression algorithm, in the data compression method provided in this application, the compression algorithm used by the computing device is selected based on the content feature of the to-be-compressed file, and the to-be-compressed file is compressed by using the compression algorithm that matches the content feature of the to-be-compressed file, so that a data compression ratio can be effectively improved, to enable a storage device to store more data, thereby improving storage space utilization of the storage device.

The content feature of the to-be-compressed file includes an application scenario feature of the to-be-compressed file. For example, if the to-be-compressed file is data related to a gene sequencing application scenario, and the to-be-compressed file includes a plurality of fsatq data blocks, the content feature of the to-be-compressed file includes a feature of the fsatq data block. For another example, if the to-be-compressed file is data related to a satellite remote sensing application scenario, and the to-be-compressed file includes a plurality of images of a same scenario represented by different bands, the content feature of the to-be-compressed file includes images represented by different bands in the same scenario. For still another example, if the to-be-compressed file is data related to a cryo-electron microscopy application scenario, the content feature of the to-be-compressed file includes a random characteristic of data distribution and presentation of an electron microscope image. For yet another example, if the to-be-compressed file is data related to a medical treatment application scenario, the content feature of the to-be-compressed file includes a plurality of encoded images.

With reference to the first aspect, in a possible implementation, the determining a compression algorithm of the to-be-compressed file based on a content feature of the to-be-compressed file includes: performing semantic analysis on the to-be-compressed file to obtain a semantic analysis result. The semantic analysis result includes a semantic boundary of the to-be-compressed file and the compression algorithm. The semantic analysis result indicates to compress, based on the compression algorithm, the to-be-compressed file divided by the semantic boundary. Semantic analysis is performed on the to-be-compressed file to understand an arrangement rule and a content feature of data in the to-be-compressed file that are identified by the to-be-compressed file, so as to guide subsequent preprocessing and compression operations, thereby improving a data compression ratio and storage space utilization of a storage device.

In an example, the computing device stores a first correspondence between a plurality of content features and compression algorithms. The determining a compression algorithm of the to-be-compressed file based on a content feature of the to-be-compressed file includes: determining a content feature that is in the first correspondence and that corresponds to the content feature of the to-be-compressed file; and determining, based on the content feature determined in the first correspondence, the compression algorithm for compressing the to-be-compressed file.

In another example, the computing device stores a second correspondence between a plurality of name suffixes and content features. The method further includes: determining a name suffix that is in the second correspondence and that corresponds to a name suffix of the to-be-compressed file; and determining the content feature of the to-be-compressed file based on the name suffix determined in the second correspondence. For example, when a content feature indicated by the semantic analysis result is the same as the content feature determined based on the name suffix in the second correspondence, the content feature of the to-be-compressed file is determined based on the content feature determined based on the second correspondence. Therefore, the computing device determines the content feature of the to-be-compressed file as quickly as possible, to increase a rate of compressing the to-be-compressed file.

Optionally, the semantic analysis result further includes a preprocessing indication. The preprocessing indication indicates to: compress a decompressed file based on the compression algorithm after the to-be-compressed file is decompressed by using a preset version compression algorithm, and store a difference between temporarily compressed data and the to-be-compressed file. The difference is used to restore the to-be-compressed file, the preset version compression algorithm is used to: decompress the to-be-compressed file to obtain the decompressed file, and compress the decompressed file to obtain the temporarily compressed data. Therefore, before the to-be-compressed file is compressed, in other words, the computing device performs, based on a preprocessing solution specified by the semantic analysis result, operations including but not limited to slicing, reorganizing, transforming (decompressing), and the like on the to-be-compressed file, the to-be-compressed file is enabled to have better compressibility.

With reference to the first aspect, in another possible implementation, the compressing the to-be-compressed file based on the compression algorithm to obtain compressed data includes: performing slicing on the to-be-compressed file based on a semantic boundary of a data block indicated by the content feature of the to-be-compressed file, to obtain a plurality of data blocks; and compressing the plurality of data blocks based on the compression algorithm to obtain the compressed data.

Optionally, the compressing the plurality of data blocks based on the compression algorithm to obtain the compressed data includes: reorganizing the plurality of data blocks based on a semantic relationship between the plurality of data blocks, to obtain a plurality of reorganized data blocks; and compressing the plurality of reorganized data blocks based on the compression algorithm to obtain the compressed data. Because the computing device performs semantic analysis on the to-be-compressed file to obtain a file format and an arrangement manner of internal data in a corresponding format file, after boundary division is performed on "non-associated data", "associated data" is reorganized and aggregated together (as a compression input), to obtain a higher compression ratio.

With reference to the first aspect, in another possible implementation, the determining a compression algorithm of the to-be-compressed file based on a content feature of the to-be-compressed file includes: performing semantic analysis on the to-be-compressed file to obtain a semantic analysis result. The semantic analysis result indicates to perform slicing at a fixed length and adaptively determine the compression algorithm. When semantic analysis is performed on the to-be-compressed file to understand an arrangement rule and a content feature of data in the to-be-compressed file that are not identified by the to-be-compressed file, the to-be-compressed file is divided at a fixed length, and the compression algorithm is adaptively selected, thereby improving storage space utilization of a storage device.

According to a second aspect, a data compression apparatus is provided. The apparatus includes modules configured to perform the method performed by the computing device in any one of the first aspect or the possible designs of the first aspect.

According to a third aspect, a computing device is provided. The computing device includes a processor and a communication interface, the communication interface communicates with the processor, and the processor is configured to perform the operation steps of the data compression method in any one of the first aspect or the possible implementations of the first aspect.

According to a fourth aspect, a storage system is provided. The storage system includes at least one computing node and at least one storage node, the computing node is configured to perform the operation steps of the data compression method in any one of the first aspect or the possible implementations of the first aspect, to obtain compressed data, and the storage node is configured to store the compressed data; or the computing node transmits to-be-compressed data to the storage node, and the storage node performs the operation steps of the data compression method in any one of the first aspect or the possible implementations of the first aspect to obtain compressed data, and stores the compressed data.

According to a fifth aspect, a computer-readable storage medium is provided, including computer software instructions. When the computer software instructions are run in a computing device, the computing device is enabled to perform the operation steps of the method in any of the first aspect or the possible implementations of the first aspect.

According to a sixth aspect, a computer program product is provided. When the computer program product runs on a computing device, the computing device is enabled to perform the operation steps of the method in any of the first aspect or the possible implementations of the first aspect.

Based on the implementations provided in the foregoing aspects, this application may further combine technologies in this application to provide more implementations.

### BRIEF DESCRIPTION OF DRAWINGS

FIG. 1 is a diagram of an architecture of a distributed storage system according to this application;
FIG. 2 is a diagram of a structure in which a disk and a controller are separated according to this application;
FIG. 3 is a diagram of an architecture of a centralized storage system according to this application;
FIG. 4 is a schematic flowchart of a data compression method according to this application;
FIG. 5 is a diagram of data block reorganization according to this application;
FIG. 6 is a diagram of a data compression process according to this application;
FIG. 7 is a diagram of a data compression process according to this application;
FIG. 8 is a diagram of a data compression process according to this application;
FIG. 9 is a diagram of a data compression process according to this application;
FIG. 10 is a diagram of a data compression process according to this application;
FIG. 11 is a diagram of a structure of a data compression apparatus according to this application; and
FIG. 12 is a diagram of a structure of a computing device according to this application.

### DESCRIPTION OF EMBODIMENTS

**Data compression (data compression)** refers to a method of reorganizing to-be-compressed data based on a compression algorithm, to reduce redundant data in the to-be-compressed data, so as to reduce a data amount of the to-be-compressed data, reduce storage space required for storing the to-be-compressed data, and improve a compression ratio, a transmission speed, and a compression speed of the to-be-compressed data. A specific form of a computing device for performing data compression is not limited in this application. The computing device is, for example, a mobile phone terminal, a tablet computer, a notebook computer, a virtual reality (virtual reality, VR) device, an augmented reality (augmented reality, AR) device, a mixed reality (Mixed Reality, MR) device, an extended reality (Extended Reality, ER) device, or a vehicle-mounted terminal. The computing device may alternatively be an edge device (for example, a box carrying a chip with a processing capability), a server, a device having a computing capability in a distributed storage system, or a device having a computing capability in a centralized storage system.

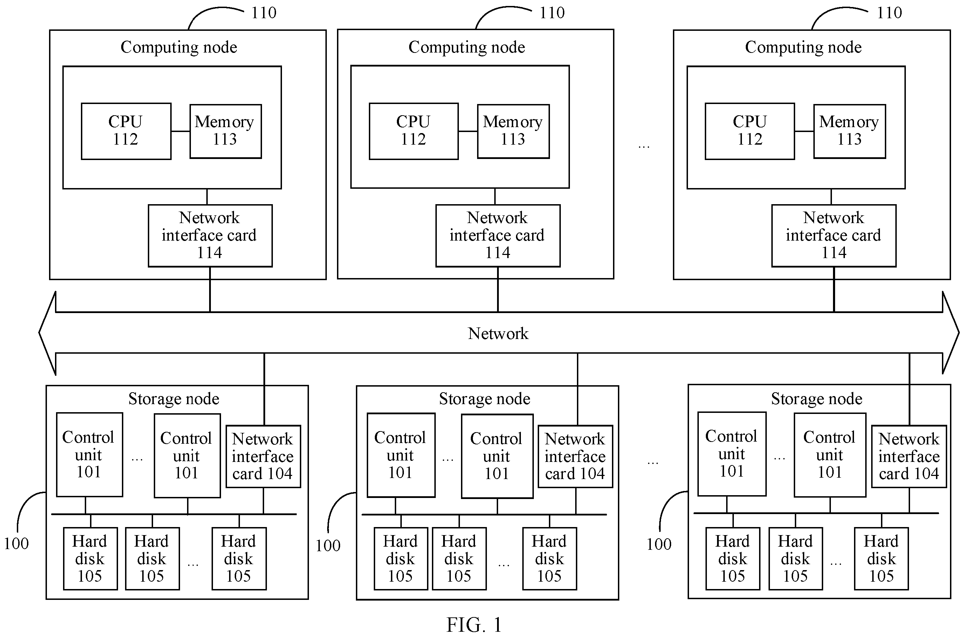

FIG. 1 is a diagram of an architecture of a distributed storage system according to this application. As shown in FIG. 1, the distributed storage system provided in this embodiment includes a computing node cluster and a storage node cluster.

The computing node cluster includes one or more computing nodes 110. FIG. 1 shows three computing nodes 110, but is not limited to three computing nodes 110. The computing nodes 110 may communicate with each other through a network. The computing node 110 is a computing device, is a node and a hub of network data, and is responsible for providing information services for a plurality of clients or users in the network, such as a server and a computer.

In terms of hardware, as shown in FIG. 1, the computing node 110 includes at least a processor 112, a memory 113, and a network interface card 114. The processor 112 is a central processing unit (central processing unit, CPU), and is configured to process a data access request from the outside of the computing node 110 or a request generated inside the computing node 110.

For example, when receiving a data write request sent by a user, the processor 112 temporarily stores data in the data write request in the memory 113. When a total amount of data in the memory 113 reaches a specific threshold, the processor 112 sends the data stored in the memory 113 to a storage node 100 for persistent storage. In addition, the processor 112 is further configured to perform computing or processing on data, for example, metadata management, deduplication, data compression, storage space virtualization, and address translation.

FIG. 1 shows only one CPU 112. In actual application, one computing node 110 may have a plurality of CPUs 112, and one CPU 112 may have one or more CPU cores. A quantity of CPUs and a quantity of CPU cores are not limited in this embodiment.

The memory 113 is an internal memory that directly exchanges data with the processor. The data can be read and written in the memory at a high speed at any time, and the memory serves as a temporary data memory of an operating system or another running program. The memory includes at least two types of memories. For example, the memory may be a random access memory, or may be a read-only memory (read-only memory, ROM). For example, the random access memory is a dynamic random access memory (dynamic random access memory, DRAM) or a storage class memory (storage class memory, SCM).

The DRAM is a semiconductor memory, and is a volatile memory (volatile memory) device like most random access memories (random access memory, RAM). The SCM uses a composite storage technology that combines characteristics of both a conventional storage apparatus and a memory. The storage class memory can provide a higher read/write speed than a hard disk, but has a lower access speed than the DRAM, and has lower costs than the DRAM. However, the DRAM and the SCM are merely examples for description in this embodiment. The memory may further include another random access memory, for example, a static random access memory (static random access memory, SRAM). For example, the read-only memory may be a programmable read-only memory (programmable read-only memory, PROM) or an erasable programmable read-only memory (erasable programmable read-only memory, EPROM).

In addition, the memory 113 may alternatively be a dual in-line memory module or a dual in-line memory module (dual in-line memory module, DIMM), that is, a module formed by a dynamic random access memory (DRAM), or may be a solid-state disk (solid-state disk, SSD).

In actual application, a plurality of memories 113 and different types of memories 113 may be configured in the computing node 110. A quantity and types of the memories 113 are not limited in this embodiment. In addition, the memory 113 may be configured to have a power protection function. The power protection function means that data stored in the memory 113 is not lost when a system is powered off and then powered on again. The memory having the power protection function is referred to as a non-volatile memory.

The network interface card 114 is configured to communicate with the storage node 100. For example, when a total amount of data in the memory 113 reaches a specific threshold, the computing node 110 may send a request to the storage node 100 through the network interface card 114, to perform persistent storage on the data. In addition, the computing node 110 may further include a bus used for communication between components in the computing node 110. In terms of functions, a main function of the computing node 110 in FIG. 1 is a computing service, and a remote memory may be used to implement persistent storage during data storage. Therefore, the computing node 110 has fewer local memories than a conventional server, thereby reducing costs and space. However, this does not mean that the computing node 110 cannot have a local memory. In actual implementation, the computing node 110 may alternatively have a small quantity of built-in hard disks or a small quantity of external hard disks. Any computing node 110 may access any storage node 100 in the storage node cluster through the network.

The storage node cluster may include a plurality of storage nodes 100. The storage node is configured to perform persistent storage on data transmitted by the computing node. FIG. 1 shows three storage nodes 100, but is not limited to three storage nodes 100. For example, there may be more than three storage nodes, or there may be less than three storage nodes.

One storage node 100 includes one or more control units 101, a network interface card 104, and a plurality of hard disks 105. The network interface card 104 is configured to communicate with the computing node 110. The hard disk 105 is configured to store data, and may be a magnetic disk or another type of storage medium, for example, a solid-state disk or a shingled magnetic recording hard disk. The control unit 101 is configured to write data into the hard disk 105 or read data from the hard disk 105 based on a data read/write request sent by the computing node 110. In a data read/write process, the control unit 101 needs to translate an address carried in the data read/write request into an address that can be identified by the hard disk. It can be seen that the control unit 101 also has some simple computing functions.

In actual application, the control unit 101 may have a plurality of forms. In one case, the control unit 101 includes a CPU and a memory. The CPU is configured to perform operations such as address translation and data read/write. The memory is configured to temporarily store data that is to be written into the hard disk 105, or read, from the hard disk 105, data that is to be sent to the computing node 110. In another case, there may be one control unit 101 or two or more control units 101. When the storage node 100 includes at least two control units 101, there may be a belonging relationship between the hard disk 105 and the control unit 101. When there is a belonging relationship between the hard disk 105 and the control unit 101, each control unit can only access a hard disk that belongs to the controller. Therefore, this generally involves forwarding a read/write data request between the control units 101, and a data access path is long. In addition, if storage space is insufficient, when a new hard disk 105 is added to the storage node 100, a belonging relationship between the hard disk 105 and the control unit 101 needs to be rebound, and an operation is complex. Consequently, scalability of the storage space is poor.

Therefore, in another implementation, a function of the control unit 101 may be offloaded to the network interface card 104. In other words, in the implementation shown in FIG. 1, the storage node 100 does not have a control unit 101 inside, but the network interface card 104 completes data read/write, address translation, and another computing function. In this case, the network interface card 104 is an intelligent network interface card, and the network interface card may contain a CPU and a memory. The CPU is configured to perform operations such as address translation and data read/write. The memory is configured to temporarily store data that is to be written into the hard disk 105, or read, from the hard disk 105, data that is to be sent to the computing node 110. There is no belonging relationship between the network interface card 104 and the hard disk 105 in the storage node 100, and the network interface card 104 may access any hard disk 105 in the storage node 100. Therefore, it is convenient to expand the hard disk when storage space is insufficient.

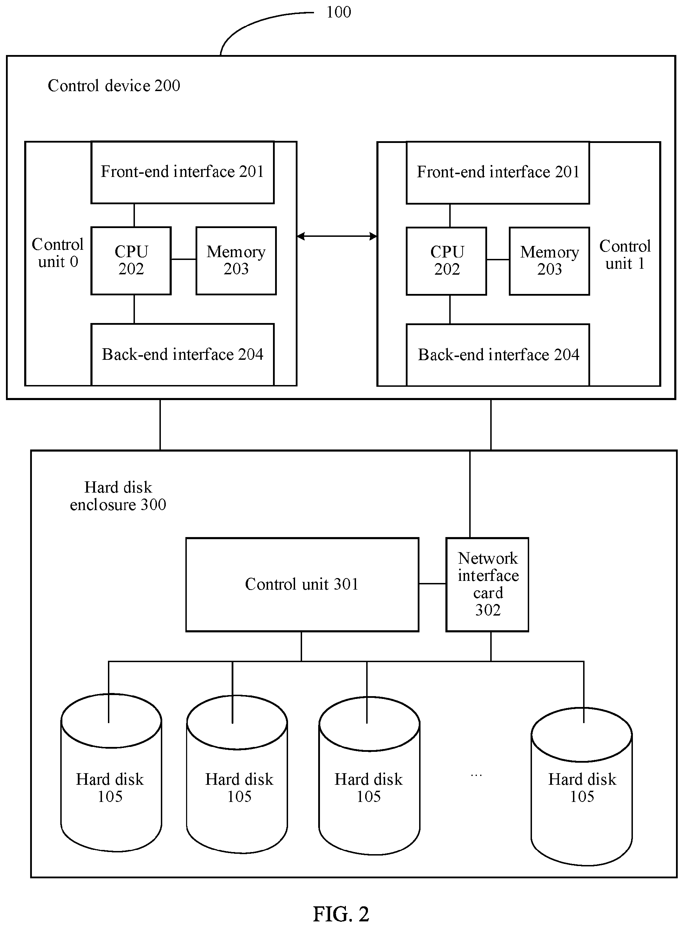

A structure of the storage node shown in FIG. 1 belongs to an architecture in which a disk and a controller are integrated, in other words, the control unit and the hard disk 105 are included in a same physical device. However, in some embodiments, a structure of the storage node may also be a structure in which a disk and a controller are separated. As shown in FIG. 2, a controller and a memory are used as two independent devices, in other words, a control device 200 and a hard disk enclosure 300 are connected to each other. The control device 200 includes a plurality of control units, for example, a control unit 0 and a control unit 1, and the plurality of control units are connected to a computing node. Each control unit has a same structure. The control unit 0 is used as an example, and the control unit 0 includes a front-end interface 201, a CPU 202, a memory 203, and a back-end interface 204. To transmit data sent by the computing node through a network interface card to the control unit 0, the back-end interface 204 is connected to the hard disk enclosure, and the data processed by the control unit 0 has been transmitted to the hard disk enclosure 300 for storage. The CPU 202 and the memory 203 are configured to process the data transmitted by the computing node or data of a locally running program. For details, refer to descriptions of the CPU 112 and the memory 113 in the computing node 110, and details are not described herein again. In addition to the hard disk 105, the hard disk enclosure 300, as an independent device, further includes a control unit 301, configured to process the data transmitted by the computing node, store the processed data in the hard disk 105, and manage the hard disk 105.

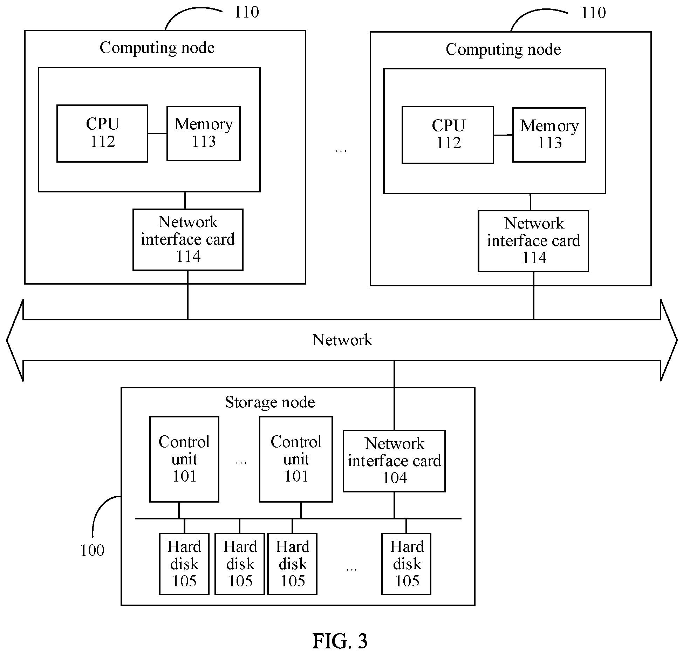

FIG. 1 is the diagram of the architecture of the distributed storage system. The solution in this embodiment of this application may be further applied to a centralized storage system. In the centralized storage system, data of a computing node is stored in a storage node, and the storage node may be, for example, a storage array. FIG. 3 shows an architecture of the centralized storage system. Structures of a storage node 100 and a computing node 110 are the same as those in FIG. 1, and details are not described herein again. The storage node 100 shown in FIG. 3 is a structure in which a disk and a controller are integrated. In the integrated storage system, the structure of the storage node may alternatively be the structure in which the disk and the controller are separated shown in FIG. 2.

According to the data compression method provided in this application, when a computing device compresses a to-be-compressed file, the computing device determines a compression algorithm of the to-be-compressed file based on a content feature of the to-be-compressed file; and compresses the to-be-compressed file based on the compression algorithm to obtain compressed data, and stores the compressed data. In this way, compared with compressing, by a computing device, files with different content features by using one compression algorithm, in the data compression method provided in this application, the compression algorithm used by the computing device is selected based on the content feature of the to-be-compressed file, and the to-be-compressed file is compressed by using the compression algorithm that matches the content feature of the to-be-compressed file, so that a data compression ratio can be effectively improved, to enable a storage device to store more data, thereby improving storage space utilization of the storage device.

The data compression method provided in this application may be applied to scenarios including but not limited to a cryo-electron microscopy scenario, a remote sensing scenario, a gene scenario, and a medical treatment scenario. The to-be-compressed file includes an image, a video, audio, text, a digit, a letter, and the like.

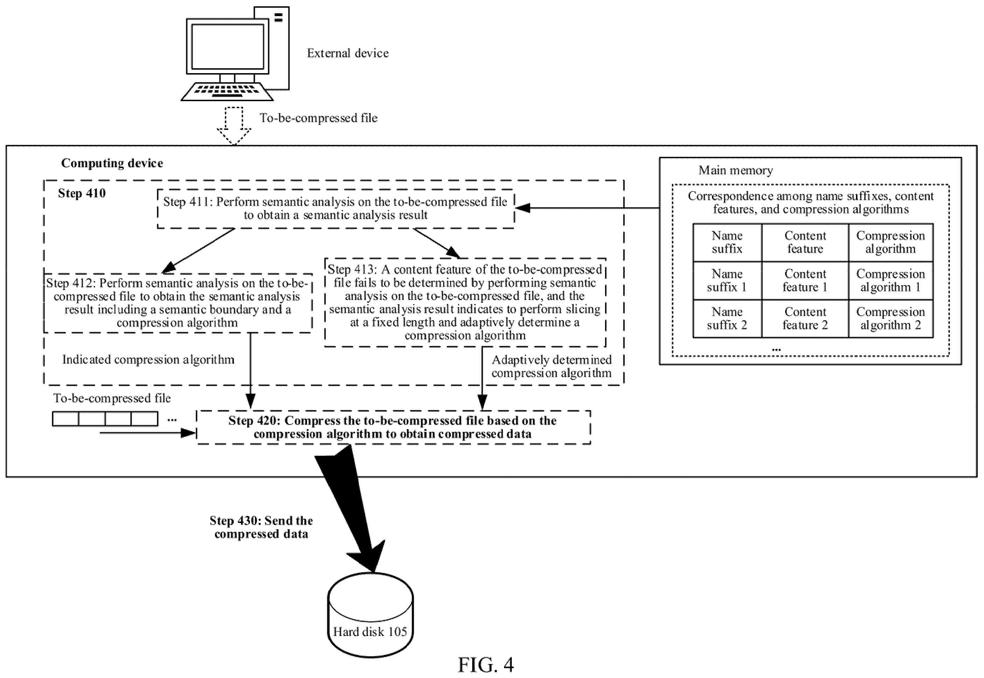

The following describes in detail the data compression method provided in this application with reference to FIG. 4 to FIG. 10. FIG. 4 is a schematic flowchart of a data compression method according to this application. As shown in FIG. 4, the method includes the following steps.

Step 410: A computing device determines a compression algorithm of a to-be-compressed file based on a content feature of the to-be-compressed file.

The computing device may receive a to-be-compressed file sent by an external device (for example, a keyboard, a mouse, a camera, or a voice receiver); or the computing device runs an application to generate a to-be-compressed file. If the computing device is a storage device, the computing device may alternatively receive, through a network, a to-be-compressed file sent by another computing device (for example, a server).

A file format (or referred to as a file type), for example, an image format, a program format, and a text format, indicates a special encoding manner of information used by the computing device to store the information. Each type of information may have one or more file formats. Files in different application scenarios also have different file formats. Table 1 is a diagram of a file format corresponding to an application scenario according to this application.

**Table 1**

| Application scenario | File format |
|---|---|
| Cryo-electron microscopy | MRC, MRCS |
| Remote sensing | TIFF, TIF, GEOTIFF |
| Gene | FASTA, FA, FNA, FASTQ, FQ, FASTA.GZ, FNA.GZ, FA.GZ, FQ.GZ, FASTQ.GZ |
| Medical treatment | KFB, SVS, SDPC |

Because files in different file formats include different arrangement rules of data, the computing device performs semantic analysis on the to-be-compressed file to determine the compression algorithm for compressing the to-be-compressed file. A specific operation process included in step 410 is described in step 411 to step 413 below.

Step 411: The computing device performs semantic analysis on the to-be-compressed file to obtain a semantic analysis result.

The computing device may identify a file format based on a name suffix of a file. A same application scenario corresponds to a plurality of name suffixes, and content features of file formats corresponding to different name suffixes may be the same. The content feature of the to-be-compressed file includes an application scenario feature of the to-be-compressed file. For example, the content feature of the to-be-compressed file indicates a format feature of the to-be-compressed file and a preprocessing manner of compressing the to-be-compressed file, and includes but is not limited to operations such as slicing, reorganizing, and transforming (decompressing).

In a possible implementation, the computing device performs step 412, that is, performs semantic analysis on the to-be-compressed file to obtain the semantic analysis result including a semantic boundary and a compression algorithm. The semantic boundary is used to indicate a boundary of different semantic data included in the to-be-compressed file. For example, the semantic boundary includes a file header boundary, a file extension header boundary, a data block boundary, and a file trailer boundary. A file extension header may also be referred to as an extension header.

In an example, the semantic boundary may be set in a file header of a file, and the computing device parses the file header to obtain the semantic boundary of the file. In another example, the semantic boundary may be set in a corresponding field. For example, the file header boundary is set in a file header; the file extension header boundary is set in a file extension header; the data block boundary is set in a data block; and the file trailer boundary is set in a file trailer. The computing device parses each field of a file to obtain a semantic boundary of the file.

In some embodiments, the computing device stores a correspondence among a plurality of name suffixes, content features, and compression algorithms. The computing device performs table lookup based on a name suffix of the to-be-compressed file, determines a name suffix that is in a correspondence and that corresponds to the name suffix of the to-be-compressed file, determines a content feature corresponding to the name suffix in the correspondence as the content feature of the to-be-compressed file, and determines a compression algorithm corresponding to the name suffix in the correspondence as the compression algorithm for compressing the to-be-compressed file.

Optionally, the computing device compares a content feature indicated by the semantic analysis result with the content feature determined based on the name suffix in the correspondence, and when the content feature indicated by the semantic analysis result is the same as the content feature determined based on the name suffix in the correspondence, the computing device determines, the compression algorithm corresponding to the name suffix in the correspondence as the compression algorithm for compressing the to-be-compressed file.

In an example, a correspondence among name suffixes, content features, and compression algorithms may be presented in a form of a table, as shown in Table 2.

**Table 2**

| Name suffix | Content feature | Compression algorithm |
|---|---|---|
| Name suffix 1 | Content feature 1 | Compression algorithm 1 |
| Name suffix 2 | | |
| Name suffix 3 | Content feature 2 | Compression algorithm 2 |
| Name suffix 4 | Content feature 3 | Compression algorithm 3 |
| ... | ... | ... |

As shown in Table 1, it is assumed that the name suffix of the to-be-compressed file is the name suffix 1. Table 2 is queried based on the name suffix 1, and it is determined that the name suffix 1 corresponds to the content feature 1 and the compression algorithm 1. If the content feature indicated by the semantic analysis result of the semantic analysis performed by the computing device on the to-be-compressed file is the same as the content feature 1, the compression algorithm of the to-be-compressed file is the compression algorithm 1 corresponding to the name suffix 1.

It should be noted that Table 1 merely shows, in a form of a table, a storage form of the correspondence in a storage device, but does not limit the storage form of the correspondence in the storage device. Certainly, the storage form of the correspondence in the storage device may alternatively be another storage form. This is not limited in this embodiment of this application.

In another example, a correspondence among name suffixes, content features, and compression algorithms may alternatively be set separately. For example, the computing device stores a second correspondence between a plurality of name suffixes and content features, and a first correspondence between content features and compression algorithms.

The computing device determines a name suffix that is in the second correspondence and that corresponds to the name suffix of the to-be-compressed file, and determines, based on the name suffix determined in the second correspondence, that a content feature corresponding to the name suffix is the content feature of the to-be-compressed file. Further, the computing device determines a content feature that is in the first correspondence and that corresponds to the content feature of the to-be-compressed file, and determines, based on the content feature determined in the first correspondence, that a compression algorithm corresponding to the content feature is the compression algorithm for compressing the to-be-compressed file.

Optionally, the semantic analysis result further includes preprocessing indications such as decompressing, slicing, and reorganizing of the to-be-compressed file. For example, the to-be-compressed file is a compressed file, but a compression ratio of the compressed file is low. After decompressing the to-be-compressed file, the computing device may re-compress the to-be-compressed file based on a compression algorithm determined by the semantic analysis result, to obtain a higher compression ratio. For another example, a plurality of data blocks in the to-be-compressed file include associated data, and the computing device may reorganize the plurality of data blocks to obtain a larger data block, and compress the reorganized data blocks. Because the computing device performs semantic analysis on the to-be-compressed file to obtain a file format and an arrangement manner of internal data in a corresponding format file, after boundary division is performed on "non-associated data", "associated data" is reorganized and aggregated together (as a compression input), to obtain a higher compression ratio.

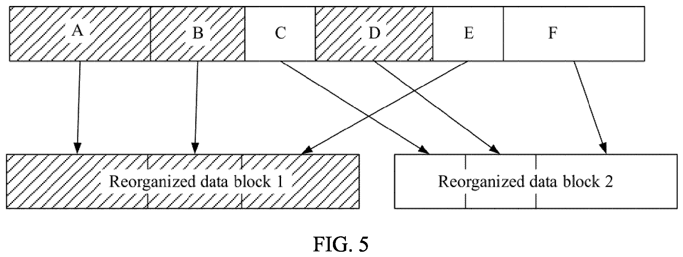

For example, as shown in FIG. 5, same filling patterns indicate "associated data", in other words, a data block A, a data block B, and a data block D are associated, and a data block C, a data block E, and a data block F are associated. Because the data block C isolates the data block A, the data block B, and the data block D, if the data block A, the data block B, and the data block D are separately encoded, a higher compression ratio cannot be obtained. The data block D isolates the data block C, the data block E, and the data block F. If the data block C, the data block E, and the data block F are separately encoded, a higher compression ratio cannot be obtained. Therefore, the computing device reorganizes the data block A, the data block B, and the data block D to obtain a reorganized data block 1, and reorganizes the data block C, the data block E, and the data block F to obtain a reorganized data block 2. The reorganized data block 1 and the reorganized data block 2 are compressed to obtain a higher compression ratio.

In another possible implementation, the to-be-compressed file does not have a name suffix, and the computing device fails to determine the content feature and the compression algorithm of the to-be-compressed file by performing semantic analysis on the to-be-compressed file, in other words, the computing device performs step 413, where the semantic analysis result indicates to perform slicing at a fixed length and adaptively determine a compression algorithm.

Step 420: The computing device compresses the to-be-compressed file based on the compression algorithm to obtain compressed data, and stores the compressed data.

The computing device compresses the to-be-compressed file based on the compression algorithm indicated by the semantic analysis result, to obtain the compressed data. The compression algorithm indicated by the semantic analysis result is a customized compression algorithm. For example, compression algorithms used by the computing device to compress the to-be-compressed file in a gene sequencing application scenario include an association compression algorithm, a public dictionary reference compression algorithm, a DG predictive compression algorithm, and entropy encoding. The association compression algorithm is used to compress a label in an fsatq data block, the public dictionary reference compression algorithm is used to compress a DNA segment in the fsatq data block, and the DG predictive compression algorithm and the entropy encoding are used to compress a quality score. For another example, a compression algorithm used by the computing device to compress the to-be-compressed file in a satellite remote sensing application scenario includes an entropy encoding compression algorithm. The entropy encoding compression algorithm is used to compress a reorganized data block of valid information obtained by reorganizing valid information represented by a plurality of bands.

When the semantic analysis result includes the semantic boundary and the compression algorithm of the to-be-compressed file, the computing device performs slicing on the to-be-compressed file based on a semantic boundary of a data block indicated by the content feature of the to-be-compressed file, to obtain a plurality of data blocks; and compresses the plurality of data blocks based on the compression algorithm to obtain the compressed data.

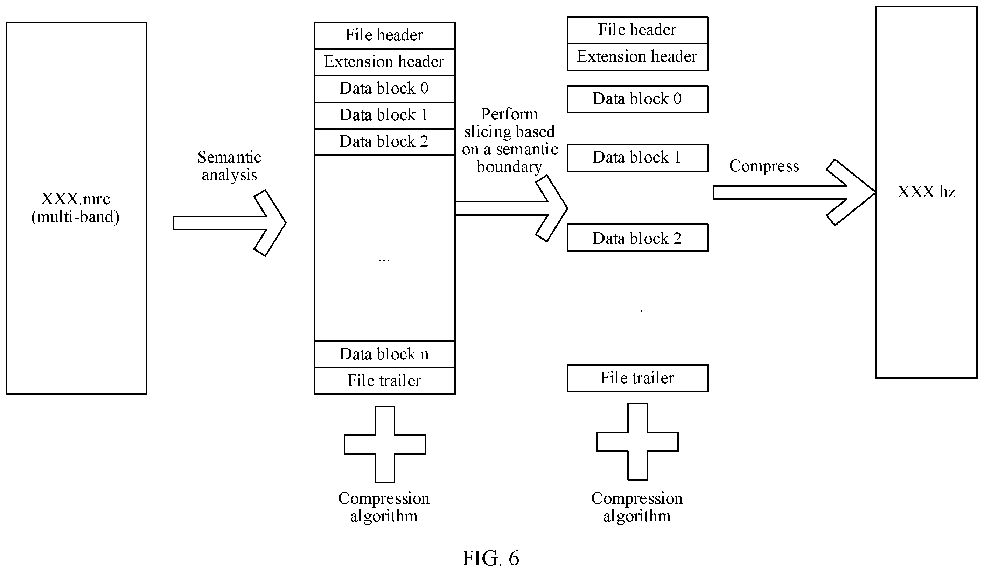

For example, as shown in FIG. 6, it is assumed that the to-be-compressed file is XXX.mrc. After performing semantic analysis on XXX.mrc, the computing device obtains metadata and a compression algorithm of XXX.mrc. The metadata indicates the semantic boundary of the to-be-compressed file, and the metadata includes a file header, a file extension header, a file trailer, and n data block boundaries. Further, the computing device performs slicing on the to-be-compressed file based on the semantic boundary to obtain a plurality of data blocks. If the plurality of data blocks do not include associated data, the computing device compresses the plurality of data blocks based on the compression algorithm to obtain compressed data, that is, XXX.hz.

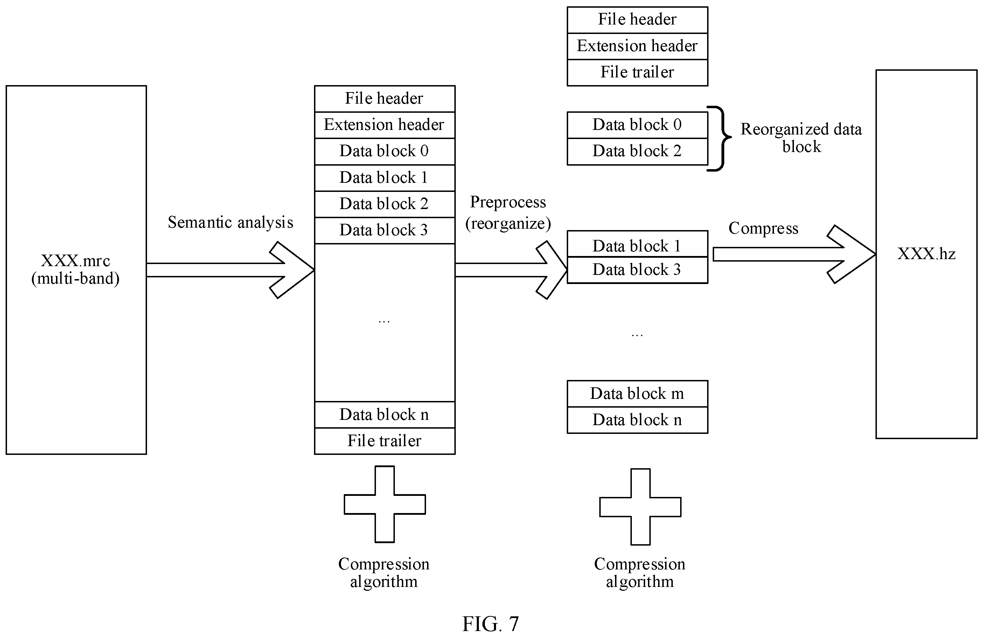

As shown in FIG. 7, it is assumed that the file header, the file extension header, and the file trailer include associated data, and a data block m and a data block n include associated data, for example, n=m+2, the computing device may reorganize the file header, the file extension header, and the file trailer, and reorganize the data block m and the data block n, for example, reorganize a data block 0 and a data block 2, and reorganize a data block 1 and a data block 3. The computing device compresses the plurality of reorganized data blocks based on the compression algorithm to obtain compressed data, that is, XXX.hz.

For example, if the to-be-compressed file is data related a satellite remote sensing application scenario, and the to-be-compressed file includes a plurality of images of a same scenario represented by different bands, the content feature of the to-be-compressed file includes images represented by different bands in the same scenario. A plurality of images of the same scenario represented by different wave bands include valid information and invalid information. The computing device may reorganize the valid information represented by a plurality of bands to obtain a reorganized data block of the valid information, and reorganize the invalid information to obtain a reorganized data block of the invalid information. Further, the computing device compresses a plurality of reorganized data blocks based on the compression algorithm to obtain the compressed data.

When the computing device fails to determine the content feature and the compression algorithm of the to-be-compressed file by performing semantic analysis, that is, the semantic analysis fails, and the semantic analysis result indicates to perform slicing at a fixed length and adaptively determine the compression algorithm, the computing device performs slicing on the to-be-compressed file at the fixed length to obtain a plurality of data blocks; and compresses the plurality of data blocks based on the adaptively determined compression algorithm to obtain the compressed data.

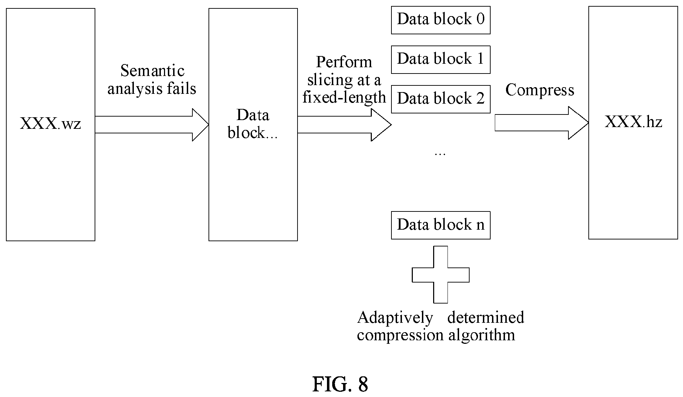

For example, as shown in FIG. 8, it is assumed that the to-be-compressed file is XXX.wz. After performing semantic analysis on XXX.wz, the computing device does not obtain metadata and a compression algorithm of XXX.wz. Further, the computing device performs slicing on the to-be-compressed file based on the fixed length to obtain a plurality of data blocks; and compresses the plurality of data blocks based on an adaptively determined compression algorithm to obtain compressed data, that is, XXX.hz.

In an example, the computing device may traverse compression algorithms corresponding to content features in the correspondence, and separately compress the to-be-compressed file based on a plurality of compression algorithms, to obtain a plurality of pieces of compressed data; and compare compression ratios of the plurality of pieces of compressed data, and select a compression algorithm with a highest compression ratio as the compression algorithm for compressing the to-be-compressed file.

In another example, the computing device may traverse compression algorithms corresponding to content features in the correspondence, and separately compress a part of data in the to-be-compressed file based on a plurality of compression algorithms, to obtain a plurality of pieces of compressed data; and compare compression ratios of the plurality of pieces of compressed data, and select a compression algorithm with a highest compression ratio as the compression algorithm for compressing the to-be-compressed file. Therefore, duration for determining the compression algorithm by the computing device is shortened. The part of data includes any data block selected from the to-be-compressed file.

Optionally, the semantic analysis result further includes a preprocessing indication. The preprocessing indication indicates to compress a decompressed file based on the compression algorithm after the to-be-compressed file is decompressed.

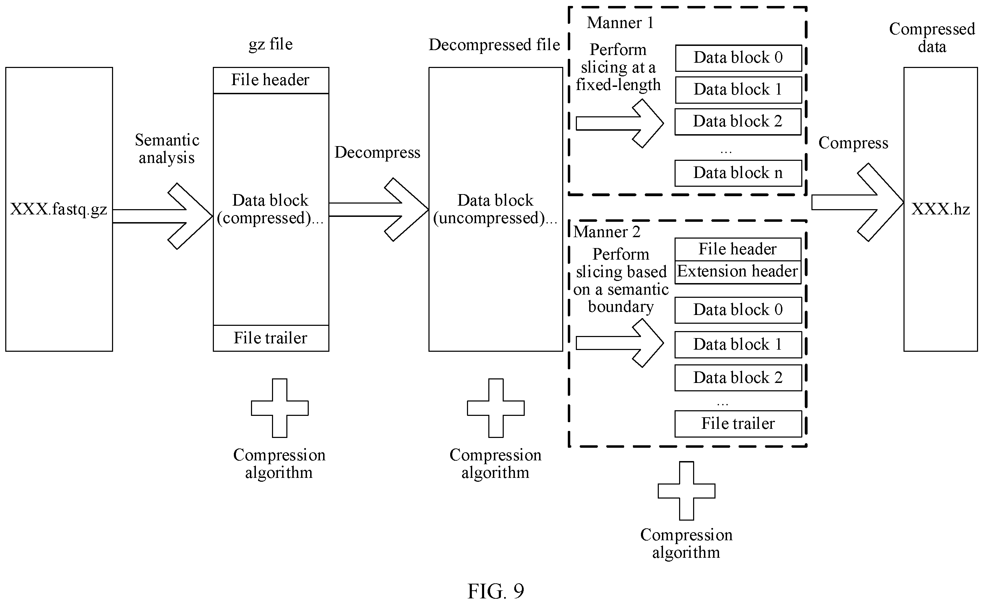

For example, as shown in FIG. 9, it is assumed that the to-be-compressed file is XXX.fastq.gz, and the to-be-compressed file is a compressed file. After performing semantic analysis on XXX.fastq.gz, the computing device obtains a file header, a data block, and a file trailer of the to-be-compressed file, and decompresses the to-be-compressed file based on a compression algorithm corresponding to the name suffix, to obtain the decompressed file. In some embodiments, the computing device performs slicing on the decompressed file based on a fixed length to obtain a plurality of data blocks; and compresses the plurality of data blocks based on an adaptively determined compression algorithm to obtain compressed data, that is, XXX.hz. In some other embodiments, the computing device performs slicing on the decompressed file based on a semantic boundary of a data block indicated by a content feature of the decompressed file, to obtain a plurality of data blocks; and compresses the plurality of data blocks based on the compression algorithm determined according to the content feature to obtain compressed data.

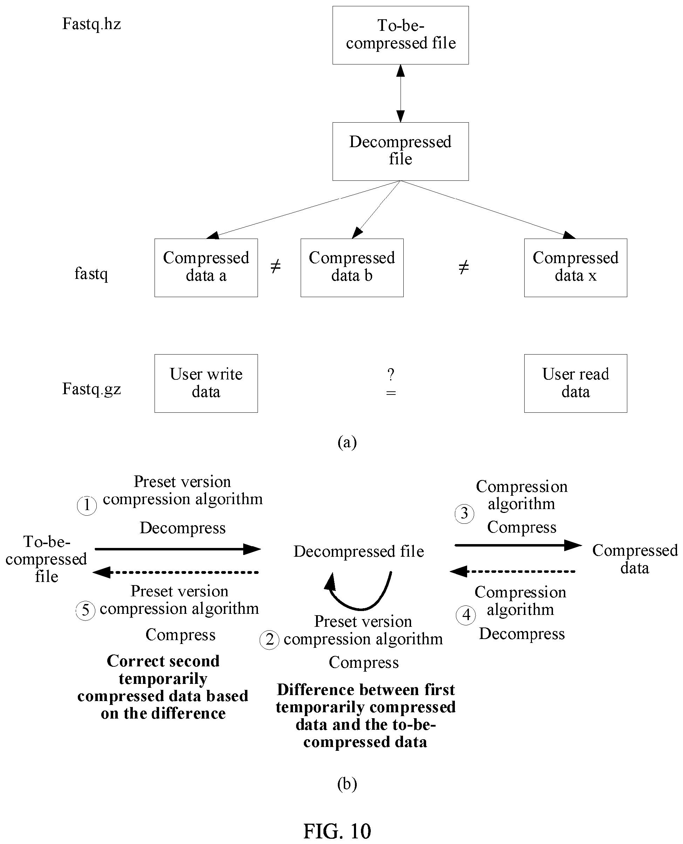

It should be noted that, because versions or levels of a same compression algorithm are different, different compressed files are obtained by compressing a same piece of uncompressed data by using different versions of a same compression algorithm. As a result, a file obtained by compressing a decompressed file based on different versions or different levels of compression algorithms may be different from a to-be-compressed file. For example, as shown in (a) in FIG. 10, it is assumed that the to-be-compressed file is fastq.gz, and a decompressed file is fastq. Different compressed files are obtained by compressing fastq by using different versions of a same compression algorithm. Compressed data includes compressed data a, compressed data b, and compressed data x. As a result, data read from a storage node may be different from data written into the storage node.

In some embodiments, the preprocessing indication further indicates a difference between temporarily compressed data and the to-be-compressed file, and the difference is used to restore the to-be-compressed file. For example, as shown in (b) in FIG. 10, ① the computing device decompresses the to-be-compressed file based on a preset version compression algorithm to obtain a decompressed file; ② the computing device compresses the decompressed file based on the preset version compression algorithm to obtain first temporarily compressed data, compares the first temporarily compressed data with the to-be-compressed file to obtain a difference, uses the difference as metadata, and stores the difference; ③ the computing device compresses the decompressed file based on the compression algorithm determined based on the content feature of the to-be-compressed file, to obtain compressed data; further, ④ when restoring the to-be-compressed file, the computing device decompresses the compressed data based on the compression algorithm to obtain the decompressed file; and ⑤ the computing device compresses the decompressed file based on the preset version compression algorithm to obtain second temporarily compressed data, and corrects the second temporarily compressed data based on the difference to obtain the to-be-compressed file.

Step 430: The computing device sends the compressed data to the storage device.

The computing device may send a data packet to the storage device (for example, a hard disk 105), and the data packet includes the compressed data. The data package also includes a difference between the temporarily compressed data and the to-be-compressed file.

In this embodiment of this application, semantic analysis is performed on the to-be-compressed file to understand an arrangement rule and a content feature of data in the to-be-compressed file that are identified by the to-be-compressed file, so as to guide subsequent preprocessing and compression operations. The semantic analysis result includes a preprocessing solution and a compression algorithm. After the semantic analysis is completed and before the to-be-compressed file is compressed, operations including but not limited to slicing, reorganizing, transforming (decompressing), and the like are performed on the to-be-compressed file based on the preprocessing solution specified by the semantic analysis result, so that the to-be-compressed file has better compressibility. Finally, compression is completed based on the compression algorithm specified by the semantic analysis result or the compression algorithm adaptively matched by the content feature, to obtain an optimal compression ratio.

After reading the compressed data from the storage device, the computing device may decompress the compressed data based on the compression algorithm to obtain the original to-be-compressed file. If preprocessing operations such as reorganizing, slicing, and decompressing are performed when the to-be-compressed file is compressed, correspondingly, a reverse preprocessing operation is performed to restore an original arrangement rule of a data block, so as to obtain the to-be-compressed file.

It may be understood that, to implement functions in the foregoing embodiments, the computing device includes corresponding hardware structures and/or software modules for performing the functions. A person skilled in the art should be easily aware that, in this application, the units and method steps in the examples described with reference to embodiments disclosed in this application can be implemented by hardware or a combination of hardware and computer software. Whether a function is performed by hardware or hardware driven by computer software depends on particular application scenarios and design constraint conditions of the technical solutions.

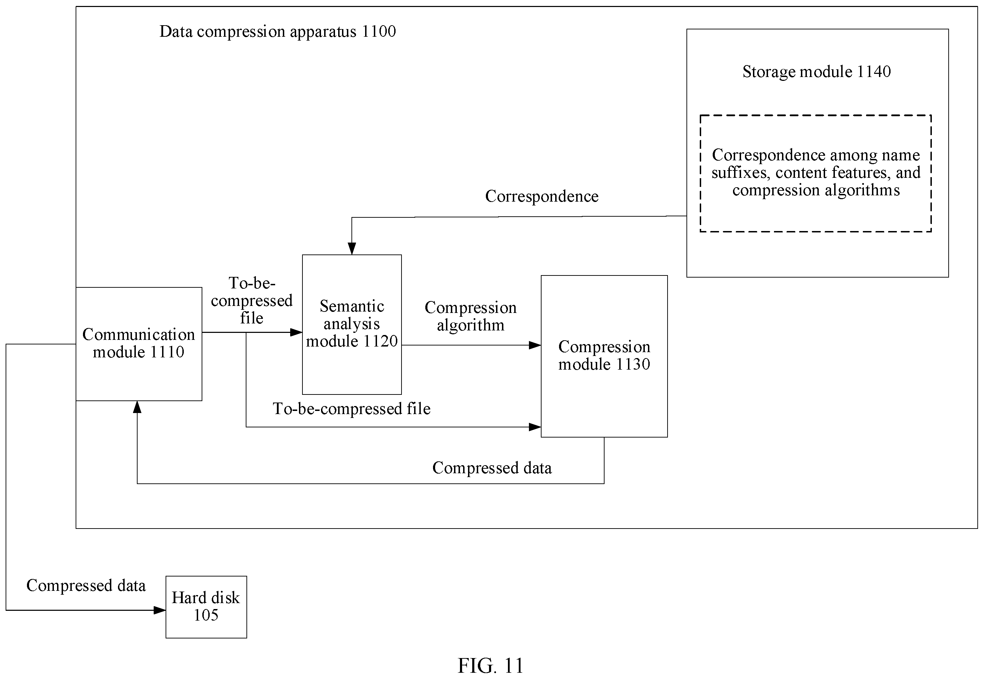

The foregoing describes in detail the data compression method provided in embodiments with reference to FIG. 1 to FIG. 10. The following describes a data compression apparatus provided in embodiments with reference to FIG. 11.

FIG. 11 is a diagram of a structure of a possible data compression apparatus according to an embodiment. The data compression apparatus may be configured to implement the function of the computing device in the foregoing method embodiments. Therefore, the data compression apparatus can also implement beneficial effects of the foregoing method embodiments. In this embodiment of this application, the data compression apparatus may be the computing device shown in FIG. 4, or may be a module (for example, a chip) used in the computing device.

As shown in FIG. 11, the data compression apparatus 1100 includes a communication module 1110, a semantic analysis module 1120, a compression module 1130, and a storage module 1140. The data compression apparatus 1100 is configured to implement the function of the computing device in the method embodiment shown in FIG. 4.

The communication module 1110 is configured to obtain a to-be-compressed file.

The semantic analysis module 1120 is configured to determine a compression algorithm of the to-be-compressed file based on a content feature of the to-be-compressed file. For example, the semantic analysis module 1120 is configured to perform step 410 in FIG. 4.

The compression module 1130 is configured to: compress the to-be-compressed file based on the compression algorithm to obtain compressed data, and store the compressed data. For example, the semantic analysis module 1120 is configured to perform step 420 in FIG. 4.

The storage module 1140 is configured to store a correspondence among a plurality of name suffixes, content features, and compression algorithms, so that the semantic analysis module 1120 determines the compression algorithm for compressing the to-be-compressed file.

The semantic analysis module 1120 is specifically configured to perform semantic analysis on the to-be-compressed file to obtain a semantic analysis result. The semantic analysis result includes a semantic boundary of the to-be-compressed file and the compression algorithm.

The semantic analysis module 1120 is specifically configured to: determine a content feature that is in the first correspondence and that corresponds to the content feature of the to-be-compressed file; and determine, based on the content feature determined in the first correspondence, the compression algorithm for compressing the to-be-compressed file.

The semantic analysis module 1120 is specifically configured to: determine a name suffix that is in a second correspondence and that corresponds to a name suffix of the to-be-compressed file; and determine the content feature of the to-be-compressed file based on the name suffix determined in the second correspondence.

The compression module 1130 is specifically configured to: perform slicing on the to-be-compressed file based on a semantic boundary of a data block indicated by the content feature of the to-be-compressed file, to obtain a plurality of data blocks; and compress the plurality of data blocks based on the compression algorithm to obtain the compressed data.

The compression module 1130 is specifically configured to: reorganize the plurality of data blocks based on a semantic relationship between the plurality of data blocks, to obtain a plurality of reorganized data blocks; and compress the plurality of reorganized data blocks based on the compression algorithm to obtain the compressed data.

It should be understood that the data compression apparatus 1100 in this embodiment of this application may be implemented by using an application-specific integrated circuit (application-specific integrated circuit, ASIC) or a programmable logic device (programmable logic device, PLD). The PLD may be a complex programmable logical device (complex programmable logical device, CPLD), a field-programmable gate array (field-programmable gate array, FPGA), generic array logic (generic array logic, GAL), or any combination thereof. Alternatively, when the data compression method shown in FIG. 4 may be implemented by software, the modules of the data compression apparatus 1100 may also be software modules, and the data compression apparatus 1100 and the modules of the data compression apparatus 1100 may also be software modules.

The data compression apparatus 1100 according to this embodiment of this application may correspondingly perform the method described in embodiments of this application, and the foregoing and other operations and/or functions of the units in the data compression apparatus 1100 are separately intended to implement corresponding procedures of the method in FIG. 4. For brevity, details are not described herein again.

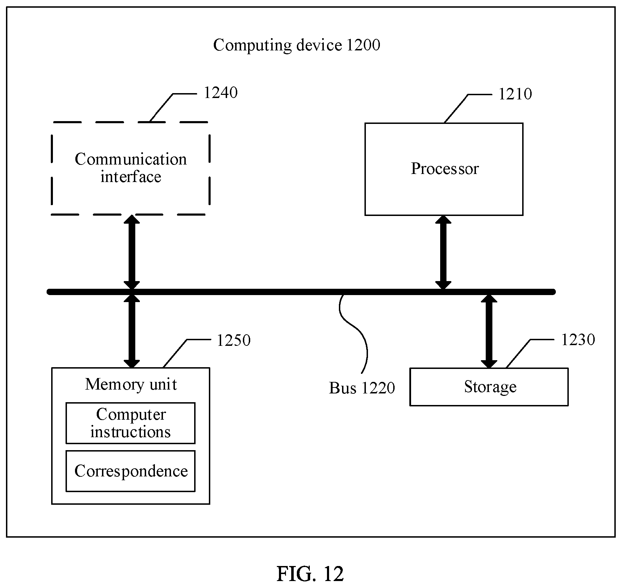

FIG. 12 is a diagram of a structure of a computing device 1200 according to an embodiment. As shown in the figure, the computing device 1200 includes a processor 1210, a bus 1220, a storage 1230, a communication interface 1240, and a memory unit 1250 (which may also be referred to as a main memory (main memory) unit). The processor 1210, the storage 1230, the memory unit 1250, and the communication interface 1240 are connected through the bus 1220.

It should be understood that, in this embodiment, the processor 1210 may be a CPU, or the processor 1210 may be another general-purpose processor, a digital signal processor (digital signal processor, DSP), an ASIC, an FPGA or another programmable logical device, a discrete gate or a transistor logical device, a discrete hardware component, or the like. The general-purpose processor may be a microprocessor or any conventional processor or the like.

Alternatively, the processor may be a graphics processing unit (graphics processing unit, GPU), a neural network processing unit (neural network processing unit, NPU), a microprocessor, an ASIC, or one or more integrated circuits configured to control program execution in the solutions of this application.

The communication interface 1240 is configured to implement communication between the computing device 1200 and an external device or a component. In this embodiment, when the computing device 1200 is configured to implement the function of the computing device shown in FIG. 4, the communication interface 1240 is configured to obtain a to-be-compressed file. The communication interface 1240 may be a network interface card, such as an Ethernet network interface card, a host bus adapter, or a data processing unit. This is not specifically limited in this application. In another implementation of this application, the processor 1210 may be integrated into the communication interface 1240 to implement the solutions in embodiments of this application. The communication interface in this embodiment of the present invention may be a front-end interface or a back-end interface, or may be a unified interface in a device.

The bus 1220 may include a path, configured to transfer information between the foregoing components (such as the processor 1210, the memory unit 1250, and the storage 1230). In addition to a data bus, the bus 1220 may further include a power bus, a control bus, a status signal bus, and the like. However, for clear description, various types of buses in the figure are denoted as the bus 1220. The bus 1220 may be a peripheral component interconnect express (Peripheral Component Interconnect Express, PCIe) bus, an extended industry standard architecture (extended industry standard architecture, EISA) bus, a unified bus (unified bus, Ubus or UB), a compute express link (compute express link, CXL) bus, a cache coherent interconnect for accelerators (cache coherent interconnect for accelerators, CCIX) bus, or the like. The bus 1220 may be classified into an address bus, a data bus, a control bus, and the like.

In an example, the computing device 1200 may include a plurality of processors. The processor may be a multi-core processor (multi-CPU). The processor herein may be one or more devices, circuits, and/or computing units configured to process data (for example, computer program instructions). In this embodiment, when the computing device 1200 is configured to implement the function of the computing device shown in FIG. 4, the processor 1210 determines a compression algorithm of the to-be-compressed file based on a content feature of the to-be-compressed file, compresses the to-be-compressed file based on the compression algorithm to obtain compressed data, and stores the compressed data.

It should be noted that, in FIG. 12, only an example in which the computing device 1200 includes one processor 1210 and one storage 1230 is used. The processor 1210 and the storage 1230 each indicate a type of component or device. In a specific embodiment, a quantity of each type of components or devices may be determined based on a service requirement.

The memory unit 1250 may correspond to the foregoing method embodiment and is configured to store information such as the correspondence among name suffixes, content features, and compression algorithms. The memory unit 1250 may be a volatile memory pool or a non-volatile memory pool, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. By way of example but not limitative description, many forms of RAMs may be used, for example, a static random access memory (static RAM, SRAM), a dynamic random access memory (DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

The storage 1230 may correspond to a storage medium, for example, a magnetic disk, such as a mechanical hard disk or a solid-state disk, configured to store information such as computer instructions and a compression algorithm in the foregoing method embodiment.

The computing device 1200 may be a general-purpose device or a special-purpose device. For example, the computing device 1200 may be an edge device (for example, a box carrying a chip with a processing capability), or the like. Optionally, the computing device 1200 may alternatively be a server or another device having a computing capability.

It should be understood that the computing device 1200 according to embodiments may correspond to the data compression apparatus 1100 in embodiments, and may correspond to a corresponding body that performs any method in FIG. 4. In addition, the foregoing and other operations and/or functions of the modules in the data compression apparatus 1100 are respectively used to implement corresponding procedures of the methods in FIG. 4. For brevity, details are not described herein again.

This application provides a storage system. The storage system includes at least one computing node and at least one storage node. The computing node is configured to perform the operation steps of the data compression method in the foregoing embodiments to obtain compressed data, and the storage node is configured to store the compressed data. Alternatively, the computing node transmits to-be-compressed data to the storage node, and the storage node performs the operation steps of the data compression method in the foregoing embodiments to obtain compressed data, and stores the compressed data.

The method steps in embodiments may be implemented in a hardware manner, or may be implemented by executing software instructions by a processor. The software instructions may include a corresponding software module. The software module may be stored in a random access memory (random access memory, RAM), a flash memory, a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), a register, a hard disk, a removable hard disk, a CD-ROM, or any other form of storage medium well-known in the art. For example, a storage medium is coupled to a processor, so that the processor can read information from the storage medium and write information into the storage medium. Certainly, the storage medium may be a component of the processor. The processor and the storage medium may be disposed in an ASIC. In addition, the ASIC may be located in a computing device. Certainly, the processor and the storage medium may alternatively exist in the computing device as discrete components.

All or some of the foregoing embodiments may be implemented by software, hardware, firmware, or any combination thereof. When software is used for implementation, all or some of embodiments may be implemented in a form of a computer program product. The computer program product includes one or more computer programs or instructions. When the computer programs or the instructions are loaded and executed on a computer, the procedures or functions in embodiments of this application are all or partially executed. The computer may be a general-purpose computer, a special-purpose computer, a computer network, a network device, user equipment, or another programmable apparatus. The computer programs or instructions may be stored in a computer-readable storage medium, or may be transmitted from a computer-readable storage medium to another computer-readable storage medium. For example, the computer programs or instructions may be transmitted from a website, computer, server, or data center to another website, computer, server, or data center in a wired manner or in a wireless manner. The computer-readable storage medium may be any usable medium that can be accessed by the computer, or a data storage device, for example, a server or a data center, integrating one or more usable media. The usable medium may be a magnetic medium, for example, a floppy disk, a hard disk, or a magnetic tape, may be an optical medium, for example, a digital video disc (digital video disc, DVD), or may be a semiconductor medium, for example, a solid-state disk (solid-state disk, SSD). The foregoing descriptions are merely specific embodiments of this application, but are not intended to limit the protection scope of this application. Any modification or replacement readily figured out by a person skilled in the art within the technical scope disclosed in this application shall fall within the protection scope of this application. Therefore, the protection scope of this application shall be subject to the protection scope of the claims.

## Claims

1. A data compression method, wherein the method is performed by a computing device, and the method comprises:
determining a compression algorithm of a to-be-compressed file based on a content feature of the to-be-compressed file; and
compressing the to-be-compressed file based on the compression algorithm to obtain compressed data, and storing the compressed data.

2. The method according to claim 1, wherein the content feature of the to-be-compressed file comprises an application scenario feature of the to-be-compressed file.

3. The method according to claim 1 or 2, wherein the determining a compression algorithm of a to-be-compressed file based on a content feature of the to-be-compressed file comprises:
performing semantic analysis on the to-be-compressed file to obtain a semantic analysis result, wherein the semantic analysis result comprises a semantic boundary of the to-be-compressed file and the compression algorithm.

4. The method according to claim 3, wherein the computing device stores a first correspondence between a plurality of content features and compression algorithms;
the determining a compression algorithm of a to-be-compressed file based on a content feature of the to-be-compressed file comprises:
determining a content feature that is in the first correspondence and that corresponds to the content feature of the to-be-compressed file; and
determining, based on the content feature determined in the first correspondence, the compression algorithm for compressing the to-be-compressed file.

5. The method according to claim 3 or 4, wherein the computing device stores a second correspondence between a plurality of name suffixes and content features, and the method further comprises:
determining a name suffix that is in the second correspondence and that corresponds to a name suffix of the to-be-compressed file; and
determining the content feature of the to-be-compressed file based on the name suffix determined in the second correspondence.

6. The method according to any one of claims 3 to 5, wherein the semantic analysis result further comprises a preprocessing indication, and the preprocessing indication indicates to: compress a decompressed file based on the compression algorithm after the to-be-compressed file is decompressed by using a preset version compression algorithm, and store a difference between temporarily compressed data and the to-be-compressed file, wherein the difference is used to restore the to-be-compressed file, and the preset version compression algorithm is used to: decompress the to-be-compressed file to obtain the decompressed file, and compress the decompressed file to obtain the temporarily compressed data.

7. The method according to any one of claims 1 to 6, wherein the compressing the to-be-compressed file based on the compression algorithm to obtain compressed data comprises:
performing slicing on the to-be-compressed file based on a semantic boundary of a data block indicated by the content feature of the to-be-compressed file, to obtain a plurality of data blocks; and
compressing the plurality of data blocks based on the compression algorithm to obtain the compressed data.

8. The method according to claim 7, wherein the compressing the plurality of data blocks based on the compression algorithm to obtain the compressed data comprises:
reorganizing the plurality of data blocks based on a semantic relationship between the plurality of data blocks, to obtain a plurality of reorganized data blocks; and
compressing the plurality of reorganized data blocks based on the compression algorithm to obtain the compressed data.

9. The method according to claim 1 or 2, wherein the determining a compression algorithm of a to-be-compressed file based on a content feature of the to-be-compressed file comprises:
performing semantic analysis on the to-be-compressed file to obtain a semantic analysis result, wherein the semantic analysis result indicates to perform slicing at a fixed length and adaptively determine the compression algorithm.

10. A data compression apparatus, wherein the apparatus comprises:
a semantic analysis module, configured to determine a compression algorithm of a to-be-compressed file based on a content feature of the to-be-compressed file; and
a compression module, configured to: compress the to-be-compressed file based on the compression algorithm to obtain compressed data, and store the compressed data.

11. The apparatus according to claim 10, wherein the content feature of the to-be-compressed file comprises an application scenario feature of the to-be-compressed file.

12. The apparatus according to claim 10 or 11, wherein when determining a compression algorithm of a to-be-compressed file based on a content feature of the to-be-compressed file, the semantic analysis module is specifically configured to:
perform semantic analysis on the to-be-compressed file to obtain a semantic analysis result, wherein the semantic analysis result comprises a semantic boundary of the to-be-compressed file and the compression algorithm.

13. The apparatus according to claim 12, wherein the apparatus stores a first correspondence between a plurality of content features and compression algorithms; and when determining a compression algorithm of a to-be-compressed file based on a content feature of the to-be-compressed file, the semantic analysis module is specifically configured to:
determine a content feature that is in the first correspondence and that corresponds to the content feature of the to-be-compressed file; and
determine, based on the content feature determined in the first correspondence, the compression algorithm for compressing the to-be-compressed file.

14. The apparatus according to claim 12 or 13, wherein the apparatus stores a second correspondence between a plurality of name suffixes and content features, and the semantic analysis module is further configured to:
determine a name suffix that is in the second correspondence and that corresponds to a name suffix of the to-be-compressed file; and
determine the content feature of the to-be-compressed file based on the name suffix determined in the second correspondence.

15. The apparatus according to any one of claims 12 to 14, wherein the semantic analysis result further comprises a preprocessing indication, and the preprocessing indication indicates to: compress a decompressed file based on the compression algorithm after the to-be-compressed file is decompressed by using a preset version compression algorithm, and store a difference between temporarily compressed data and the to-be-compressed file, wherein the difference is used to restore the to-be-compressed file, and the preset version compression algorithm is used to: decompress the to-be-compressed file to obtain the decompressed file, and compress the decompressed file to obtain the temporarily compressed data.

16. The apparatus according to any one of claims 10 to 15, wherein when compressing the to-be-compressed file based on the compression algorithm to obtain compressed data, the compression module is specifically configured to:
perform slicing on the to-be-compressed file based on a semantic boundary of a data block indicated by the content feature of the to-be-compressed file, to obtain a plurality of data blocks; and
compress the plurality of data blocks based on the compression algorithm to obtain the compressed data.

17. The apparatus according to claim 16, wherein when compressing the plurality of data blocks based on the compression algorithm to obtain the compressed data, the compression module is specifically configured to:
reorganize the plurality of data blocks based on a semantic relationship between the plurality of data blocks, to obtain a plurality of reorganized data blocks; and
compress the plurality of reorganized data blocks based on the compression algorithm to obtain the compressed data.

18. The apparatus according to claim 10 or 11, wherein when determining a compression algorithm of a to-be-compressed file based on a content feature of the to-be-compressed file, the semantic analysis module is specifically configured to:
perform semantic analysis on the to-be-compressed file to obtain a semantic analysis result, wherein the semantic analysis result indicates to perform slicing at a fixed length and adaptively determine the compression algorithm.

19. A computing device, wherein the computing device comprises a communication interface and a processor, the communication interface communicates with the processor, and the processor is configured to perform the operation steps of the method according to any one of claims 1 to 9.

20. A storage system, wherein the storage system comprises at least one computing node and at least one storage node, the computing node is configured to perform the operation steps of the method according to any one of claims 1 to 9, to obtain compressed data, and the storage node is configured to store the compressed data; or the computing node transmits to-be-compressed data to the storage node, and the storage node performs the operation steps of the method according to any one of claims 1 to 9, to obtain compressed data, and stores the compressed data.
